# EUROPEAN PATENT SPECIFICATION

(11) **EP 0 520 832 B1**
(45) Date of publication and mention of the grant of the patent: **20.03.1996**
(21) Application number: 92305950.5
(22) Date of filing: 29.06.1992
(51) Int. Cl.: C23C 16/50, C23C 16/26, H01Q 19/00

(54) **Plasma assisted diamond synthesis**
Plasmaunterstützte Diamantherstellung
Synthèse de diamant assisté par plasma

(30) Priority: 28.06.1991 GB 9114014
(43) Date of publication of application: 30.12.1992
(73) Proprietor: DE BEERS INDUSTRIAL DIAMOND DIVISION (PROPRIETARY) LIMITED, Johannesburg, Transvaal (ZA)
(72) Inventor: Wort, Christopher John Howard, Wantage, Oxen OX12 7DG (GB); Sussmann, Ricardo Simon, Guildford, Surrey GU1 2NT (GB); Holliday, Harry Richard, Leominster Herefordshire (GB); Hawkins, Dennis Charles, Leominster Herefordshire (GB)
(74) Representative: Senior, Alan Murray

(56) References cited:
- EP-A- 0 106 698
- US-A- 4 434 188
- PATENT ABSTRACTS OF JAPAN vol. 13, no. 137 (C-582)(3485) 5 April 1989 & JP-A-63 302 938, 9 December 1988
- PATENT ABSTRACTS OF JAPAN vol. 13, no. 546 (C-661)(3894) 6 December 1989 & JP-A-1 222 054, 5 September 1989
- PATENT ABSTRACTS OF JAPAN vol. 1, no. 117 (E)6 October 1977 -A-52 050 143, 21 April 1977

## Description

This invention relates to the synthesis of diamond and other ceramic materials using a plasma assisted chemical vapour deposition (CVD) technique.

Diamonds have been produced synthetically for the past three or so decades by subjecting a carbon source such as graphite to a pressure exceeding 50 kilobars and a temperature exceeding 1200°C in the presence of a catalyst metal such as nickel, cobalt or iron. More recently, diamonds have been synthesised from the gas phase. This method is known as chemical vapour deposition (CVD) and the diamond produced is known as CVD diamond. The process generally involves providing a mixture of hydrogen gas and a suitable gaseous carbon compound such as a hydrocarbon, applying sufficient energy to that gas to dissociate the hydrogen into atomic hydrogen and the gas into active carbon ions, atoms or CH radicals and allowing such active species to deposit on a substrate to form diamond. Dissociation of the gases can take place by a variety of methods.

One such method is the use of a hot filament to dissociate the gases in the region around the filament. A second commonly used method is a plasma assisted method. The hydrogen and gaseous carbon compound enter a plasma region, which may be microwave-,RF-or DC- formed plasma, where they are excited to their active states. They diffuse in this state onto a substrate, which is heated by the plasma. Microwave plasma assisted CVD has, in the past, used waveguides to generate the plasma inside a reaction chamber contained within the waveguide. The intense electric field generated within the confines of the waveguide, or the waveguide cavity, is sufficient to ionise the low pressure gasses contained within the reaction chamber. The plasma thus generated deposits diamond onto a substrate placed in the plasma, or adjacent thereto.

A disadvantage of the use of a waveguide to form a plasma is that the size of the plasma is determined by the dimensions of the waveguide enclosure. An increase in the size of the plasma cannot merely be effected by increasing the size of a waveguide, as, without a proportional increase in microwave wavelength, multi-mode propagation occurs. This results in the inefficient generation of plasma.

As the plasma is confined to the electric field lines present within the waveguide, its position is static within the reaction chamber. This presents additional problems. Firstly, the insertion of a substrate into the waveguide disrupts the electric field lines in an unpredictable manner, which is dependent upon the nature and the geometry of the substrate. Secondly, the plasma can come into contact with the walls of the reaction chamber that are unavoidably within the confines of the waveguide. This can lead to contamination of the diamond deposit on the substrate.

US-A-4,434,188, on which the preambles of the independent claims have been based, discloses a method and apparatus for synthesizing diamond in which a microwave source is used to create a plasma above a substrate in a gas including hydrogen gas into which is introduced a hydrocarbon.

According to, one aspect of the present invention there is provided a method of forming a plasma for assisting in the production of diamond by chemical vapour deposition, comprising the steps of :
(i) providing a reaction chamber;
(ii) locating a substrate within the reaction chamber;
(iii) generating microwave radiation from a remote source;
   and
(iv) introducing into the reaction chamber a mixture of a gaseous carbon compound and an active gas, wherein said active gas is chosen from a group including hydrogen and oxygen,
   characterised in that the microwave radiation is generated as a beam, and by the steps of :
(v) using focusing means to focus the microwave radiation to a focal point adjacent the substrate to form a plasma within the reaction chamber in the region of the substrate; and
(vi) scanning the plasma over the substrate by adjusting the position of the substrate and the focusing means relative to one another, so as to cause chemical vapour deposition of diamond onto the substrate.

Advantageously the method includes the step of focusing the beam of microwave radiation diffraction limited spot so as to form a localized plasma and writing diamond onto the substrate by scanning the plasma over the surface of the substrate, and preferably the diffraction limited spot has a diameter of approximately half the wavelength of the incoming microwave radiation.

Advantageously the method includes the step of providing at least two external sources of microwave radiation at different frequencies, and focusing both sources of microwave radiation to at least one focal point to form a plasma within the reaction chamber, the two different frequencies being arranged selectively to excite specific species within the plasma.

Preferably the beam of microwave radiation is polarized in at least two different directions in differing ratios arranged to refine the plasma.

Preferably the shape of the plasma is independent of the shape of the reaction chamber and dependent on the geometry and positioning of the focusing means.

According to another aspect of the present invention, there is provided an apparatus for use in forming a plasma for assisting in the production of diamond, and which is for use with a remote source of microwave radiation;
means for introducing a mixture of a gaseous carbon compound and an active gas which is chosen from a group including hydrogen and oxygen for forming a plasma,
wherein in use a substrate is located within the reaction chamber, and the plasma is arranged to cause chemical vapour deposition of diamond onto the substrate
   characterised in that :
the apparatus further comprises focusing means located externally of the reaction chamber for focusing a beam of microwave radiation from said remote source to a focal region within the reaction chamber where the plasma is to be formed, so that the shape of the plasma is independent of the shape of the reaction chamber and dependent on the geometry and positioning of the focusing means; and
the focusing means and the substrate are adjust able relative to one another so as to allow the plasma at the focal region to be scanned over the substrate.

Advantageously the remote source includes at least two microwave generators arranged to generate microwaves of different frequencies for exciting different species within the plasma.

The focusing means may comprise at least one reflector having a concave reflective surface dimensioned to be at least four times the wavelength of the microwave radiation.

More specifically, the focusing means may comprise first and second parabolic reflectors, the first reflector being arranged to receive a beam of microwave radiation from a microwave generator and to transmit the beam to the second reflector, which is arranged to focus the beam.

The means for introducing the selected gas may include a vacuum pump for evacuating the reaction chamber, a pressurized source of the selected gas communicating with the reaction chamber, and valve means for controlling the supply of the selected gas to the reaction chamber.

The invention is not limited to the formation of diamond by chemical vapour deposition. Numerous other ceramic materials, including Si, GaS, InP, ZnS, ZnSe, GeC, SiC, and cubic boron nitride may be formed, by using a suitable precursor gas mixture. The plasma may also be used in the etching and surface modification of material. For example, it may be used in the removal of oxide layers prior to brazing, or alternatively in the reflow of brazes and solders.

By the term microwave radiation, for the purposes of this specification, it is meant that the radiation has a possible frequency range from 300MHz to 1000GHz, preferably from 433MHz to 94GHz, and more preferably in the region between 2GHz and 3GHz.

In order that the invention may be better understood, the following description is given, merely by way of example, with reference to the accompanying drawings, in which :
- Figure 1: shows a highly schematic view of a first embodiment of plasma forming apparatus of the invention;
- Figures 2 to 5: show schematic views of further embodiments of plasma forming apparatus of the invention in which various focusing arrangements are employed, and
- Figures 6 and 7: show schematic views of an experimental arrangement for creating a suitable plasma.

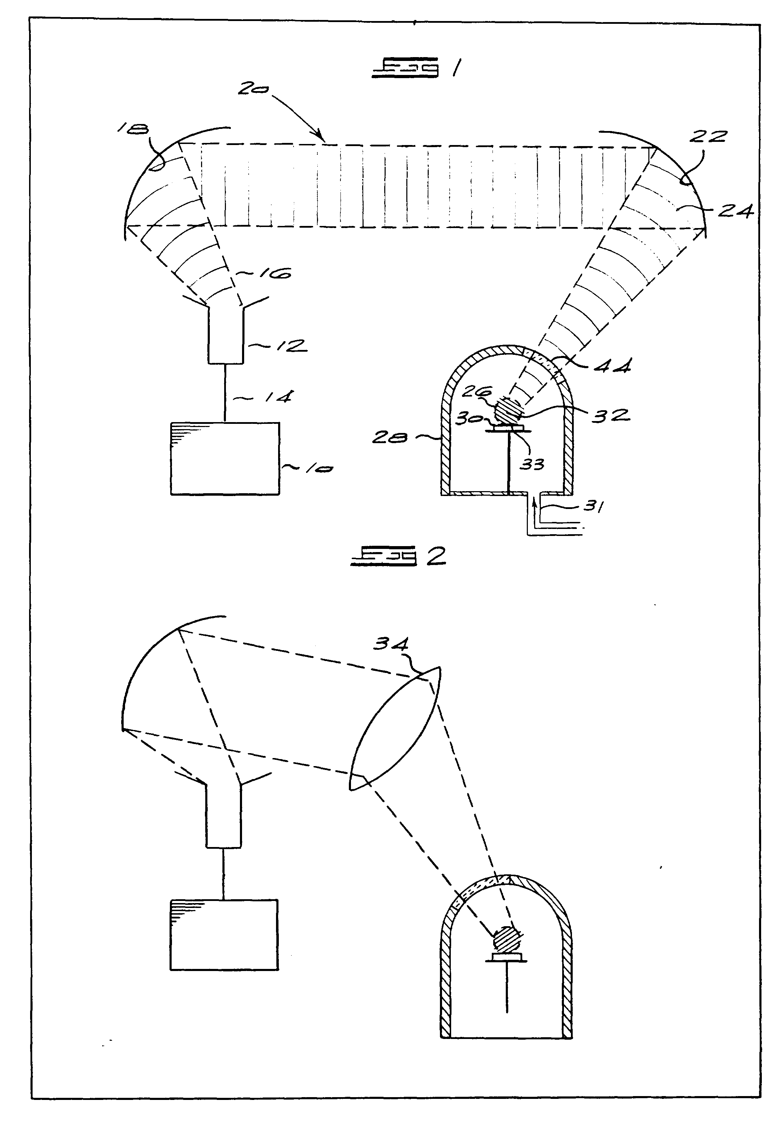

Referring now to Figure 1, a microwave generator 10 powers a radiating horn 12 via a suitable waveguide 14. The horn 12 is positioned to radiate a beam 16 of microwave radiation onto a first curved parabolic reflector 18. The reflector 18 has a suitable reflecting surface geometry in order to enable the incoming beam 16 to be reflected as a parallel plane wave 20 through free space. The plane wave train 20 is collected by a second reflector 22, which has a substantially parabolic reflecting surface for transforming the plane wave train 20 into a convergent spherical wave train 24. The convergent spherical wave train 24 converges to a focal point or region 26 which is located within a reaction chamber 28, such as a bell jar, which defines a plasma-forming zone 29.

Housed within the reaction chamber 28 towards the centre thereof is a suitable substrate 30 such as silicon carbide, molybdenum, silicon or even a diamond seed. It is clear from the drawing that the substrate 30 is positioned just beneath the focal point 26.

A carbon containing gas is combined with hydrogen, oxygen, argon, helium, neon, water vapour, or any functioned combination thereof, and is introduced into the reaction chamber 28 via an inlet pipe 31 at a pressure of between 0,1 and 700 Torr (13·3 and 93,3 × 10³ Pa), and preferably from 40 to 200 Torr (5·33 × 10³ to 26·7 × 10³ Pa). If sufficient power, in excess of 1Wcm⁻³, is concentrated within the focal region 26, then a plasma 32 is generated in the low pressure gases contained within the reaction chamber 28. As is schematically illustrated, the plasma 32 is concentrated at the focal point 26 of the second reflector 24. The substrate is heated by the hot plasma gases to a temperature of between 400K and 1500K. This temperature is usually in the region of 900K. Diamond deposition (33) occurs on the substrate 30, in a manner similar to that described in US Patent 4434188 to Kamo.

In contrast to prior art reaction chambers, which are limited by the size of the waveguide cavity within which they are confined, the size of the reaction chamber 28 is not limited by any waveguide dimensions. As a result, the substrate 30 may be placed well away from the walls of the reaction chamber and other sources of contamination. Furthermore, as there are no cavity nodes within the reaction chamber, the insertion of a substrate has little, if any affect on the position of the plasma discharge 32. Similarly, the nature and geometry of the substrate 30 has negligible effect on the plasma discharge 32.

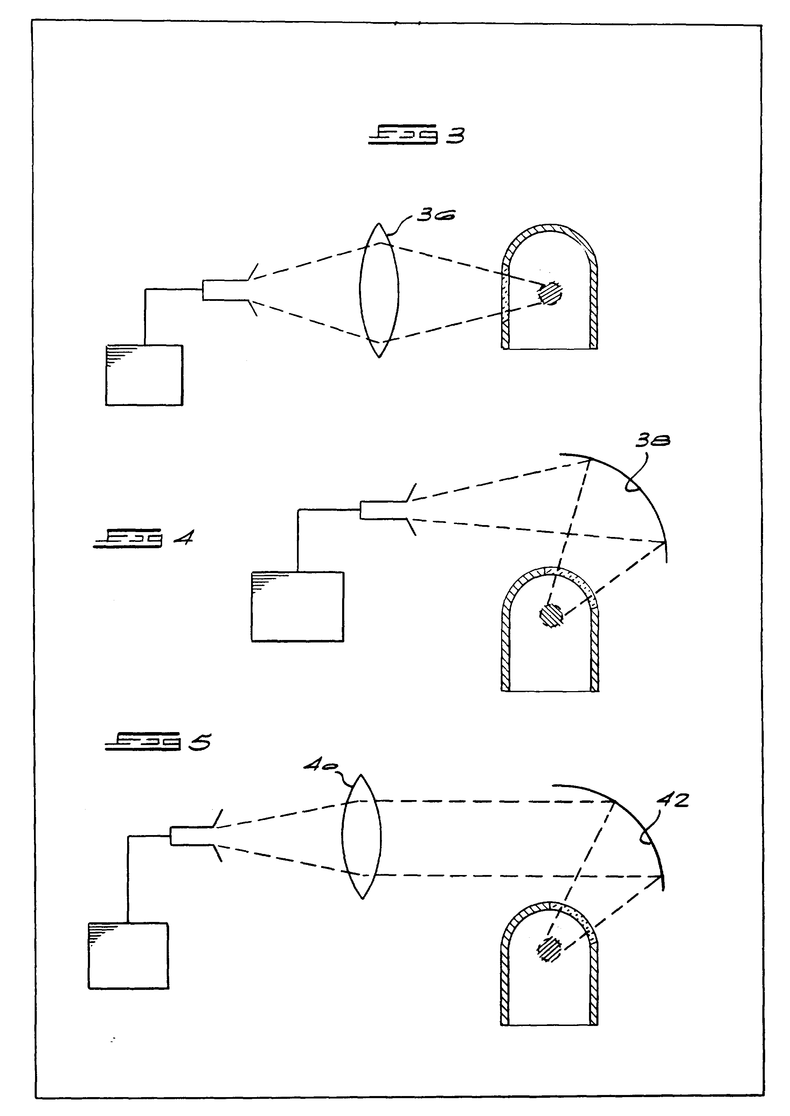

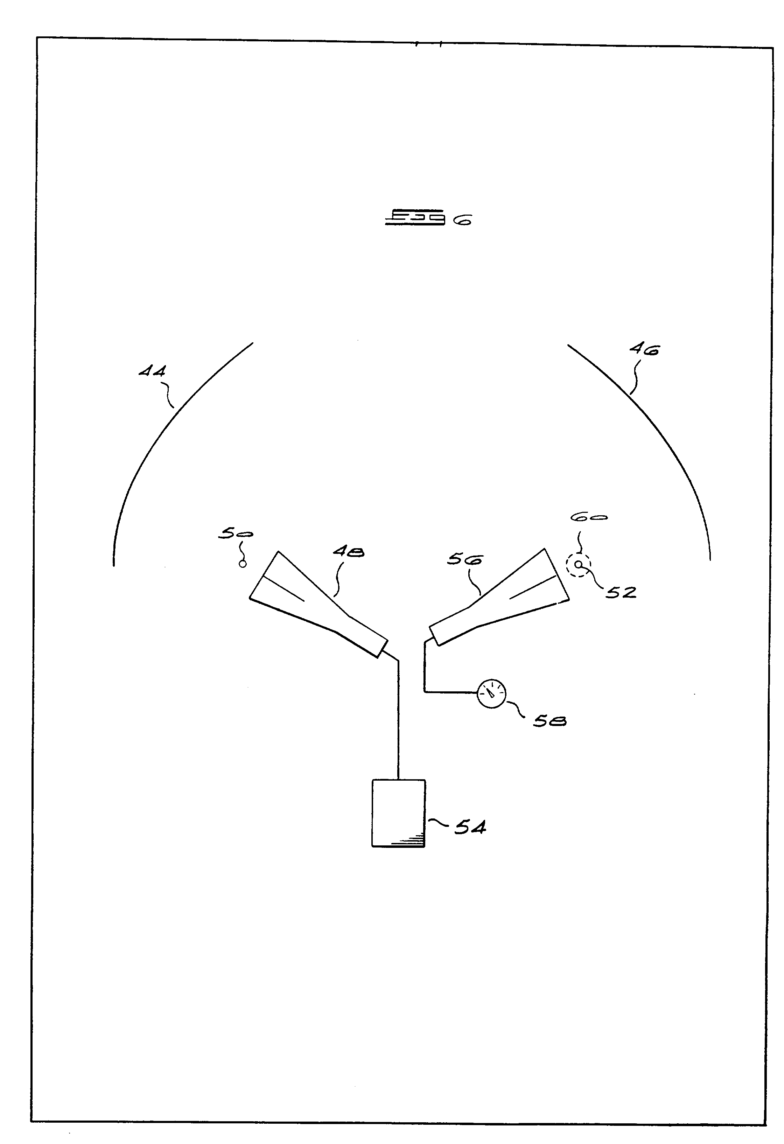

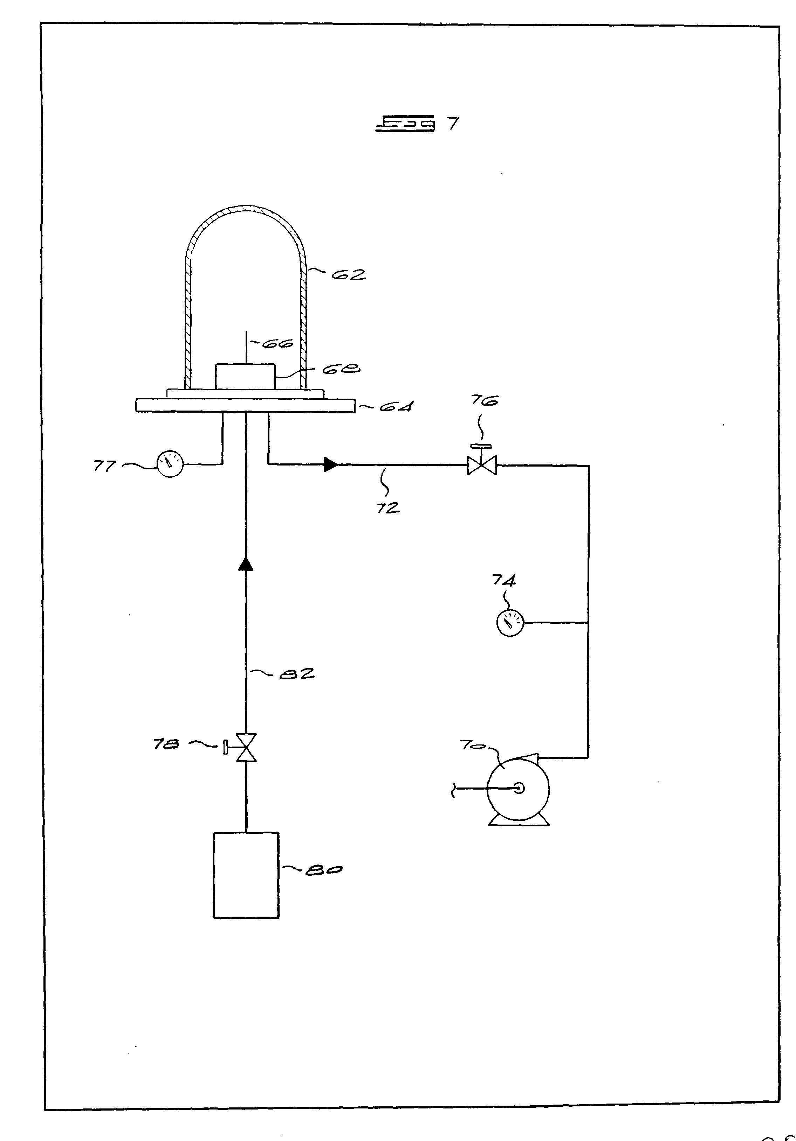

Referring now to Figure 2, a further embodiment is shown in which a lens 34 replaces the second mirror 22 of Figure 1 as a means of focusing the microwave radiation. In Figure 3, a single bi-convex lens 36 replaces both the first reflector 18 and the second reflector 22. The lens may be a dielectric lens, a metal plate lens or a fresnel zone plate lens. The arrangement illustrated in Figure 4 utilises a single reflector 38 in place of the lens 36. In Figure 5, a lens 40 is used to collimate the beam of microwave radiation, and a reflector 42 focuses the collimated beam. It should be appreciated that various combinations of lenses and reflectors may be used to focus the beam of microwave radiation, which may be continuous, pulsed, modulated or polarized, or a combination of these. For instance, an ellipsoid having a reflective inner surface may be used, with the microwave source and the plasma being located at the two respective focal points within the ellipsoid.

An advantage of the various focusing systems employed is that they may be used to obtain different plasma shapes by altering the profiles of the focusing lens or the reflector. For example, a roughly spheroidal plasma can be obtained by using a reflector that has a paraboloid reflecting surface. A bi-convex lens may also be used to achieve a similar spheroidal plasma. An elongate linear plasma may be obtained by means of a parabolic reflecting surface which is in the form of a section of a parabolic cylinder, or by a spherical reflecting surface. Further plasma shapes, as well as plasma density profiles, may be obtained by subtle variation in the microwave optics.

It is also possible to change the size and position of the plasma by adjusting the focal length of the focusing optics and by moving the final focusing device along or around its central axis of symmetry.

Scanning of the plasma in three dimensions may also be achieved by movement of the final focusing optics or of the substrate within the reaction chamber in a suitable manner. Three-dimensional surfaces may be coated with diamond by simply scanning the plasma over the entire surface of the substrate.

Several radiating horns could also be used to illuminate the first reflector or the first lens. At least two frequencies could thus be coupled within the plasma, which could, for example, be advantageously used in the selective excitation of specific species within the plasma. Similarly, two polarisation directions could be combined in differing ratios to make possible further refinements to the plasma discharge.

In a further embodiment of the invention, very high microwave frequencies could be focused to an extremely small diffraction limited spot having a diameter of approximately half the wavelength of the incoming microwave radiation, thereby enabling tiny, localised plasmas to be created. Such plasmas could then be scanned over a substrate surface in the manner described previously in the specification, in order to enable diamond to be "written" onto the substrate.

In order to minimise edge effects and to give efficient illumination of the optics, the microwave optics typically need to be large (i.e. at least four times, and preferably at least ten times) the microwave wavelength. Potentially hazardous radiation may be eliminated by enclosing the optics either in a metallic screen or by means of a suitable absorbing material.

The reaction chamber 28 should either be transparent in its entirety, or could alternatively be provided with a transparent window 44 which must be in the form of a dielectric, in order to be transparent to the microwave radiation. A further possibility is for the reaction chamber to be of such a size that it encloses both the focusing arrangement and the substrate. Preferable materials for the entire reaction chamber or for the window 44 are fused silica, quartz, zirconia, alumina, pyrex, PTFE, Macor®, silica glass or polystyrene. These materials could be coated with an anti-reflection medium in order to minimise reflection losses from the surfaces. The materials may also be cooled by means of a suitable transparent fluid such as cyclohexane.

### EXAMPLE

A prototype system was outdoors comprising a microwave generator, an arrangement of focusing microwave dishes and a reaction chamber in the form of a quartz bell jar. A plasma of several centimetres across was successfully generated in space using a microwave generator having a power of only 800 watts.

Referring to Figure 6, a pair of offset parabolic reflectors 44 and 46 were manufactured from wooden ribs with a stainless steel mesh stretched across the ribs. Parabolic templates were used to check the surface accuracy of the reflectors 44 and 46 to within ± 2mm (one sixtieth of a wavelength), which was well within typical permissible tolerances. The leakage through the mesh was calculated to be -20dB(1%). The reflectors each had a cross-sectional dimension of 1.5m, or twelve wavelengths. The focal length of each reflector was fixed at 1.5m. An antenna horn 48 having 10dB beam widths of 42° in the E-plane and 59° in H-plane was positioned just rearwardly of the focal point 50 of the reflector 44. The azimuth subtended angle of the reflector was approximately 56° and the elevations subtended angle of the reflector was 44°, resulting a relatively good match between the horn 48 and the reflector 44, provided that the horn was mounted with its E-plane vertical.

The second parabolic reflector 46 was located with its focal point 52 being approximately two meters away from the focal point 50 of the reflector 44. A magnetron transmitter 54 having a frequency of operation of 2.45GHz and an output power of approximately 1.6 kW was arranged to feed the horn 48. The peak power density of the horn aperture was calculated as being 54kW m⁻. At a distance of 1.5m, which represented the distance between the aperture of the horn 48 and the reflector 44, the power density dropped to a calculated value of 3.15kWm⁻. Owing to the arrangement of reflectors 44 and 46, it was calculated that most of the microwave radiation reflected from the reflector 44 would be captured by the reflector 46.

The reflector 44 was mounted on a fixed structure, and the reflector 46 was mounted on a trolley which ran along a track. A horn 56 and a power meter 58 were positioned adjacent the focal point 52 of the removable reflector 46, and the magnetron transmitter 54 was replaced by low power transmitter. The final positions of the reflectors 44 and 46 are indicated in Figure 6, with the respective foci 50 and 52 of the reflectors being 2.08m apart. The measured loss between the reflectors 44 and 46 was approximately 2.7dB. This was higher than expected, which was probably due to spillover at the edges of the reflectors 44 and 46 as well as a higher mesh leakage than had been calculated. The horn 48 was then connected to the magnetron transmitter 54, which was water-cooled, and driven from a remote power supply. The horn 56 was removed and the field region of the focal point 52 was probed using a neon discharge tube suspended by a fine cotton thread. The neon discharge tube struck in the region having a diameter of between 5 and 8 centimetres. The position of maximum power was also located by using a block of absorbent foam covered in heat sensitive paper.

An arrangement similar to that indicated in Figure 6 was then provided, with the horn 56 being replaced by a quartz bell jar 62. The bell jar 62 was mounted on the movable platform 64, and a thin wire dipole 66 about 1.5mm in diameter and 60mm in length was placed on a piece of low loss foam 68 within the bell jar 62. The bell jar 62 was then evacuated by being brought down to 13,3 Pa (0.1 Torr) by means of a vacuum pump 70 via a pipe 72. A pressure indicator 74 indicated the reduction in pressure in the pipe 72, and a valve 76 was closed once the required pressure had been attained as indicated by the gauge 77. A valve 78 was then opened, causing the bell jar 62 to be filled from a source of argon 80 via a pipe 82. Once the pressure within the bell jar 62 reached 1.0 Torr (133 Pa), the valve 76 was then opened and the pump 70 was then operated to evacuate the jar 62 back down to 0.1 Torr (13·3 Pa). The jar 62 was then sealed, and the magnetron transmitter 54 was then activated, causing a focused beam of microwave radiation in the region of the dipole 66 to form a plasma of approximately five to eight centimetres in diameter.

The argon was subsequently replaced by a mixture of H₂ and CH₄, gas in a volume ratio of 100:1. This gas mixture was passed continuously through the bell jar at a rate of 200 sccmin. A silicon carbide substrate approximately 5mm square replaced the foam 68 and the dipole 66. The pressure within the bell jar was maintained at 40 Torr (5·33 × 10³ Pa), and the magnetron transmitter was then activated, causing a plasma to form adjacent the substrate. This plasma caused the substrate to attain a temperature of 1170 K, maintained by cooling. This resulted in a layer of diamond forming on the substrate by chemical vapour deposition at an observed growth rate of 1 µm per hour.

## Claims

1. A method of forming a plasma (32) for assisting in the production of diamond by chemical vapour deposition, comprising the steps of :
(i) providing a reaction chamber (28);
(ii) locating a substrate (30) within the reaction chamber;
(iii) generating microwave radiation from a remote source (10); and
(iv) introducing into the reaction chamber (28) a mixture of a gaseous carbon compound and an active gas, wherein said active gas is chosen from a group including hydrogen and oxygen,
characterised in that the microwave radiation is generated as a beam (16), and by the steps of :
(v) using focusing means (18, 22; 34; 36; 38; 40, 42) to focus the microwave radiation to a focal point (26) adjacent the substrate to form a plasma (32) within the reaction chamber in the region of the substrate; and
(vi) scanning the plasma (32) over the substrate (30) by adjusting the position of the substrate (30) and the focusing means relative to one another, so as to cause chemical vapour deposition of diamond (33) onto the substrate.

2. A method according to claim 1, including the steps of focusing the beam of microwave radiation (16) to a diffraction limited spot (26) so as to form a localized plasma (32) and writing diamond (33) onto the substrate (30) by scanning the plasma over the surface of the substrate.

3. A method according to claim 2, wherein the diffraction limited spot has a diameter of approximately half the wavelength of the incoming microwave radiation.

4. A method according to any one of the preceding claims, including the step of providing at least two external sources (10, 54) of microwave radiation at different frequencies, and focusing both sources of microwave radiation to at least one focal point (26) to form a plasma (32) within the reaction chamber, the two different frequencies being arranged selectively to excite specific species within the plasma.

5. A method according to any one of the preceding claims, wherein the beam of microwave radiation (16) is polarized in at least two different directions in differing ratios arranged to refine the plasma (32).

6. A method according to any one of the preceding claims, wherein the shape of the plasma (32) is independent of the shape of the reaction chamber and dependent on the geometry and positioning of the focusing means (18,22;34;26;40,42).

7. An apparatus for use in forming a plasma for assisting in the production of diamond, and which is for use with a remote source of microwave radiation, said apparatus comprising :
a reaction chamber (28), at least a portion (44) of which is transparent to microwave radiation; and
means (78,82) for introducing a mixture of a gaseous carbon compound and an active gas which is chosen from a group including hydrogen and oxygen for forming a plasma,
wherein in use a substrate (30) is located within the reaction chamber, and the plasma is arranged to cause chemical vapour deposition of diamond (33) onto the substrate (30),
characterised in that :
the apparatus further comprises focusing means (18,22;34;36;38;40;42) located externally of the reaction chamber for focusing a beam of microwave radiation (16) from said remote source to a focal region (29) within the reaction chamber where the plasma is to be formed, so that the shape of the plasma is independent of the shape of the reaction chamber and dependent on the geometry and positioning of the focusing means; and
the focusing means and the substrate are adjustable relative to one another so as to allow the plasma at the focal region (29) to be scanned over the substrate (30).

8. An apparatus according to claim 7, wherein the remote source includes at least two microwave generators (10, 54) arranged to generate microwaves of different frequencies for exciting different species within the plasma.

9. An apparatus according to either one of claims 7 or 8, wherein the focusing means comprises at least one reflector (18,22,44,46) having a concave reflective surface dimensioned to be at least four time the wavelength of the microwave radiation.

10. An apparatus according to claim 9 wherein the focusing means comprises first and second parabolic reflectors (18,44;22,46), the first reflector (18, 44) being arranged to receive a beam of microwave radiation (16) from a microwave generator (10) and to transmit the beam (20) to the second reflector (22,46), which is arranged to focus the beam, the second parabolic reflector (22,46) and the substrate (30) being adjustable relative to one another so as to allow the plasma (32) to be scanned over the substrate.

11. An apparatus according to any one of claims 7 to 10, wherein the means arranged to introduce the selected gas includes a vacuum pump (70) for evacuating the reaction chamber, a pressurized source of the selected gas (80) communicating with the reaction chamber, and valve means (78) for controlling the supply of the selected gas to the reaction chamber.

12. A method of producing diamond by chemical vapour deposition, the method including forming a plasma either by a method according to any one of claims 1 to 6 or by using an apparatus according to any one of claims 7 to 11.

## Patentansprüche

1. Methode zur Bildung eines Plasmas (32), das die Herstellung von Diamanten mit Hilfe der Gasphasenabscheidung nach chemischem Verfahren unterstützt, bestehend aus den folgenden Schritten:
(i) Bereitstellen einer Reaktionskammer (28);
(ii) Positionieren eines Substrats (30) innerhalb der Reaktionskammer;
(iii) Erzeugen einer Mikrowellenstrahlung in einer extern angeordneten Quelle (10); und
(iv) Einführen einer Mischung einer gasförmigen Kohlenstoffverbindung und eines aktiven Gases in die Reaktionskammer (28), wobei das besagte aktive Gas aus einer Gruppe gewählt wird, der Wasserstoff und Sauerstoff angehören,
**dadurch gekennzeichnet**, daß die Mikrowellen in Form eines Strahlenbündels (16) erzeugt werden, weiterhin **gekennzeichnet durch** folgende Schritte:
(v) Verwendung von Fokussiervorrichtungen (18, 22; 34; 36; 38; 40, 42) zum Fokussieren der Mikrowellenstrahlung auf einen Brennpunkt (26) in unmittelbarer Nähe des Substrats zum Bilden eines Plasmas (32) innerhalb der Reaktionskammer im Bereich des Substrats; und
(vi) Scannen des Plasmas (32) über das Substrat (30) durch Justieren der Position des Substrats (30) und der Fokussiervorrichtung relativ zueinander, so daß eine Gasphasenabscheidung von Diamanten (33) nach chemischem Verfahren auf dem Substrat erfolgen kann.

2. Verfahren nach Anspruch 1 mit Fokussierung des Mikrowellenstrahls (16) auf einen beugungsbegrenzten Fleck (26) derart, daß ein örtlich festliegendes Plasma (32) entsteht, wobei das Abscheiden des Diamanten (33) auf dem Substrat (30) durch Scannen des Plasmas über die Oberfläche des Substrats erfolgt.

3. Verfahren nach Anspruch 2, wobei der beugungsbegrenzte Fleck einen Durchmesser hat, der etwa der Hälfte der Wellenlänge der einfallenden Mikrowelle hat.

4. Verfahren nach einem der vorgenannten Ansprüche, wobei die Bereitstellung von mindestens zwei externen Mikrowellenstrahlungsquellen (10, 54) unterschiedlicher Frequenzen eingeschlossen ist, wobei beide Mikrowellenstrahlungsquellen auf mindestens einen Brennpunkt (26) fokussiert werden müssen, damit ein Plasma (32) innerhalb der Reaktionskammer entsteht, wobei die beiden unterschiedlichen Frequenzen so gewählt werden müssen, daß sie spezielle Arten innerhalb des Plasmas anregen.

5. Verfahren nach einem der vorgenannten Ansprüche, wobei der Mikrowellenstrahl (16) vorzugsweise in mindestens zwei unterschiedlichen Richtungen mit unterschiedlichen Verhältnissen polarisiert wird, um das Plasma feinabzustimmen.

6. Verfahren nach einem der vorgenannten Ansprüche, wobei die Form des Plasmas (32) unabhängig von der Form der Reaktionskammer, aber abhängig von der Geometrie und der Positionierung der Fokussiervorrichtungen (18, 22; 34; 26; 40, 42) ist.

7. Vorrichtung für die Bildung eines Plasmas zur Unterstützung der synthetischen Herstellung von Diamanten in Verbindung mit der Verwendung eines externen Mikrowellengenerators, wobei besagte Vorrichtung besteht aus:
einer Reaktionskammer (28), die über mindestens eine Sektion (44) besteht, die für Mikrowellenstrahlen durchlässig ist; und
Vorrichtungen (78, 82) zum Injizieren einer Mischung aus gasförmigen Kohlenstoffverbindungen und einem aktiven Gas, das aus einer Gruppe gewählt wird, zu der auch Wasserstoff und Sauerstoff gehören, und das zur Plasmabildung eingesetzt wird;
wobei in der praktischen Anwendung ein Substrat (30) in der Reaktionskammer positioniert wird und das Plasma so beeinflußt wird, daß sich durch Gasphasenabscheidung nach chemischem Verfahren Diamanten (33) auf dem Substrat (30) abscheiden;
**dadurch gekennzeichnet**, daß die Vorrichtung weiterhin Fokussiervorrichtungen (18, 22; 34; 36; 38; 40; 42) beinhaltet, die außerhalb der Reaktionskammer positioniert sind und einen aus der besagten externen Quelle stammenden Mikrowellenstrahl (16) auf einen Punkt (29) innerhalb der Reaktionskammer fokussieren, in dem das Plasma gebildet werden soll, so daß die Form des Plasmas unabhängig von der Form der Reaktionskammer, aber abhängig von der Geometrie und der Positionierung der Fokussiervorrichtung ist; und
wobei die Fokussiervorrichtungen und das Substrat relativ zueinander so einstellbar sind, daß das Plasma im Fokusbereich (29) über das Substrat (30) gescannt werden kann.

8. Vorrichtung nach Anspruch 7, wobei die externe Strahlungsquelle mindestens zwei Mikrowellengeneratoren (10, 54) aufweist, um Mikrowellen unterschiedlicher Frequenzen zum Anregen unterschiedlicher Arten innerhalb des Plasmas erzeugen zu können.

9. Vorrichtung nach einem der Ansprüche 7 oder 8, wobei die Fokussiervorrichtungen aus mindestens einem Reflektor (18, 22, 44, 46) mit einer konkaven Reflexionsfläche bestehen, die so dimensioniert ist, daß sie mindestens dem Vierfachen der Wellenlänge der Mikrowellenstrahlung entspricht.

10. Vorrichtung nach Anspruch 8, wobei die Fokussiervorrichtungen einen ersten und einen zweiten Parabolreflektor (18, 44; 22, 46) beinhalten, und wobei der erste Reflektor (18, 44) so angeordnet ist, daß er ein Mikrowellenstrahlungsbündel (16) von einem ersten Mikrowellengenerator (10) erhält und diesen Strahl (20) auf einen zweiten Reflektor (22, 46) überträgt, der diese Strahlen fokussiert, wobei der erste Parabolreflektor (22, 46) und das Substrat (30) relativ zueinander in ihrer Position verstellbar sind, so daß ein Scannen des Plasmas (32) über das Substrat erfolgen kann.

11. Vorrichtung nach einem der Ansprüche 7 bis 10, wobei die Vorrichtung zum Einleiten des ausgesuchten Gases aus einer Vakuumpumpe (70) zum Evakuieren der Reaktionskammer, einem mit der Reaktionskammer verbundenen Kompressor zum Injizieren des Gases (80) in die Kammer und einem Ventil (78) zum Steuern des Zustroms des Gases in die Reaktionskammer besteht.

12. Methode zur Herstellung von Diamantüberzügen durch Gasphasenabscheidung nach chemischem Verfahren, wobei diese Methode die Erzeugung eines Plasmas durch eine der in Ansprüchen 1 bis 6 beschriebenen Methoden oder durch eine Vorrichtung nach einem der Ansprüche 7 bis 11 erfolgt.

## Revendications

1. Procédé pour former un plasma (32) pour aider dans la production de diamants par déposition en phase vapeur par procédé chimique, comprenant les étapes suivantes :
(i) procurer une chambre de réaction (28);
(ii) positionner un substrat (30) à l'intérieur de la chambre de réaction;
(iii) créer un rayonnement hyperfréquence en provenance d'une source à distance (10); et
(iv) introduire dans la chambre de réaction (28) un mélange d'un composé de carbone gazeux et d'un gaz actif, ledit gaz actif étant choisi dans un groupe comprenant l'hydrogène et l'oxygène,
caractérisé en ce que le rayonnement hyperfréquence est créé sous forme d'un faisceau (16), et par les étapes suivantes :
(v) utiliser des moyens de focalisation (18, 22; 34; 36; 38; 40, 42) pour focaliser le rayonnement hyperfréquence sur un point focal (26) adjacent au substrat pour former un plasma (32) à l'intérieur de la chambre de réaction dans la région du substrat; et
(vi) balayer le substrat (30) par le plasma (32) en réglant la position du substrat (30) et des moyens de focalisation l'un par rapport aux autres de façon à provoquer une déposition en phase vapeur par procédé chimique du diamant (33) sur le substrat.

2. Procédé selon la revendication 1, comprenant les étapes suivantes : focaliser le faisceau de rayonnement hyperfréquence (16) sur un point limité de diffraction (26) de façon à former un plasma localisé (32) et déposer du diamant (33) sur le substrat (30) en balayant la surface du substrat avec le plasma.

3. Procédé selon la revendication 2, dans lequel le point limité de diffraction a un diamètre d'environ la moitié de la longueur d'onde du rayonnement hyperfréquence entrant.

4. Procédé selon l'une quelconque des revendications précédentes, comprenant l'étape dans laquelle on procure au moins deux sources extérieures (10, 54) de rayonnement hyperfréquence à des fréquences différentes, et on focalise les deux sources de rayonnement hyperfréquence sur au moins un point focal (26) pour former un plasma (32) à l'intérieur de la chambre de réaction, les deux fréquences différentes étant agencées pour exciter sélectivement des espèces spécifiques à l'intérieur du plasma.

5. Procédé selon l'une quelconque des revendications précédentes, dans lequel le faisceau de rayonnement hyperfréquence (16) est polarisé dans au moins deux directions différentes en des rapports différents agencés pour raffiner le plasma (32).

6. Procédé selon l'une quelconque des revendications précédentes, dans lequel la forme du plasma (32) est indépendante de la forme de la chambre de réaction et dépend de la géométrie et du positionnement des moyens de focalisation (18, 22; 34; 26; 40, 42).

7. Appareil utilisé pour former un plasma pour aider dans la production de diamants et qui est prévu pour être utilisé avec une source de rayonnement hyperfréquence à distance, ledit appareil comprenant une chambre de réaction (28) dont au moins une portion (44) est transparente vis-à-vis du rayonnement hyperfréquence; et
des moyens (78, 82) pour introduire un mélange d'un composé de carbone gazeux et d'un gaz actif choisi dans un groupe comprenant l'hydrogène et l'oxygène pour former un plasma,
dans lequel, en utilisation, un substrat (30) est positionné à l'intérieur de la chambre de réaction et le plasma est agencé pour provoquer une déposition en phase vapeur par réaction chimique de diamant (33) sur le substrat (30);
caractérisé en ce que :
l'appareil comprend en outre des moyens de focalisation (18, 22; 34; 36; 38; 40, 42) situés à l'extérieur de la chambre de réaction pour focaliser un faisceau de rayonnement hyperfréquence (16) en provenance de ladite source à distance sur une région focale (29) à l'intérieur de la chambre de réaction où le plasma doit être formé de telle sorte que la forme du plasma est indépendante de la forme de la chambre de réaction et dépend de la géométrie et du positionnement des moyens de focalisation; et
les moyens de focalisation et le substrat sont réglables l'un par rapport aux autres pour permettre au plasma au niveau de la région focale (29) de balayer le substrat (30).

8. Appareil selon la revendication 7, dans lequel la source à distance comprend au moins deux générateurs hyperfréquence (10, 54) agencés pour produire des rayonnements hyperfréquence de fréquences différentes pour exciter des espèces différentes à l'intérieur du plasma.

9. Appareil selon l'une ou l'autre des revendications 7 ou 8, dans lequel les moyens de focalisation comprennent au moins un réflecteur (18, 22, 44, 46) ayant une surface réfléchissante concave dimensionnée pour avoir au moins quatre fois la longueur d'onde du rayonnement hyperfréquence.

10. Appareil selon la revendication 8, dans lequel les moyens de focalisation comprennent un premier et un deuxième réflecteur parabolique (18, 44; 22, 46), le premier réflecteur (18, 44) étant disposé pour recevoir un faisceau de rayonnement hyperfréquence (16) d'un générateur d'hyperfréquence (10) et pour transmettre le faisceau (20) au deuxième réflecteur (22, 46), lequel est agencé pour focaliser le faisceau, le deuxième réflecteur parabolique (22, 46) et le substrat (30) étant réglables l'un par rapport à l'autre de façon à permettre au plasma (32) de balayer le substrat.

11. Appareil selon l'une quelconque des revendications 7 à 10, dans lequel les moyens agencés pour introduire le gaz sélectionné comprennent une pompe à vide (70) pour faire le vide dans la chambre de réaction, une source pressurisée du gaz sélectionné (80) communiquant avec la chambre de réaction, et des moyens de vanne (78) pour régler la fourniture du gaz sélectionné à la chambre de réaction.

12. Procédé pour produire du diamant par déposition en phase vapeur par voie chimique, le procédé consistant à former un plasma, soit par un procédé selon l'une quelconque des revendications 1 à 6, soit en utilisant un appareil selon l'une quelconque des revendications 7 à 11.
